# EUROPEAN PATENT APPLICATION

(11) **EP 4 683 162 A1**
(43) Date of publication of application: **21.01.2026**
(21) Application number: 25183032.9
(22) Date of filing: 16.06.2025
(51) Int. Cl.: H02J 7/00, B60L 58/10

(54) **ELECTRICITY STORAGE SYSTEM AND LIMITING METHOD**

(30) Priority: 12.07.2024 JP 2024112089
(71) Applicant: Prime Planet Energy & Solutions, Inc., Chuo-ku, Tokyo 103-0022 (JP)
(72) Inventor: KATAOKA, Masahiro, Tokyo, 103-0022 (JP)
(74) Representative: Kuhnen & Wacker Patent- und Rechtsanwaltsbüro PartG mbB

(57) **Abstract**

An electricity storage system includes a load and multiple electricity storage units connected to the load. Each of the electricity storage units is connected to the load and includes a battery pack including multiple battery cells, a contactor provided between the battery pack and the load, and a controller. The controller includes a determination controller that determines whether an abnormality has occurred in the electricity storage unit and a supply limiting controller that, when it is determined by the determination section that an abnormality has occurred in the electricity storage unit, limits a maximum amount of electric power that is supplied to the load in a stepwise manner in accordance with a level of the abnormality of the electricity storage unit.

## Description

The present disclosure relates to an electricity storage system and a limiting method.

### BACKGROUND

For example, Japanese Laid-open Patent Publication No. 2001-185228 discloses a power source device including multiple battery modules connected in parallel and a control circuit. A current detection circuit and a switch are connected to each of the battery modules in series. The control circuit is configured to turn one of the switches that is connected to one of the battery modules in which a direction of a current detected by a corresponding one of the current detection circuits is an opposite direction to a normal direction or one of the switches that is connected to one of the battery modules in which unbalance of a current is larger than a set value from on to off.

For example, Japanese Patent No. 4542536 discloses a power source control device that performs control on an electricity storage capacitor as a control target. The electricity storage capacitor includes multiple series units connected in parallel. Each of the series units includes multiple electricity storage elements directly connected thereto.

The power source control device includes a detection device that detects detection information including a level of deterioration of each of the series units and a current distribution device that performs control such that an amount of a current that passes through each of the series units is distributed in accordance with the level of deterioration of each of the series units.

### SUMMARY

Incidentally, for example, in Japanese Laid-open Patent Publication No. 2001-185228, there is a probability that an abnormality occurs in each of the battery modules. Even when an abnormality occurs in the battery modules, electric power in an amount as large as possible is preferably supplied to a load in a range in which safety is ensured.

An electricity storage system disclosed herein includes a load and multiple electricity storage units connected to the load. Each of the electricity storage units includes a battery pack that is connected to the load and includes multiple battery cells, a contactor provided between the battery pack and the load, and a controller. The controller includes a determination controller that determines whether an abnormality has occurred in the electricity storage unit and a supply limiting controller that, when it is determined by the determination controller that an abnormality has occurred in the electricity storage unit, limits a maximum amount of electric power that is supplied to the load in a stepwise manner in accordance with a level of the abnormality of the electricity storage unit.

According to the electricity storage system disclosed herein, when an abnormality has occurred in any one of the multiple electricity storage units, the maximum amount of electric power that is supplied to the load is limited in a stepwise manner in accordance with a level of the abnormality of the electricity storage unit in which the abnormality has occurred. Accordingly, even when the abnormality has occurred in the electricity storage unit, electric power in an amount as large as possible can be supplied to the load in accordance with a type of the abnormality.

A limiting method disclosed herein is a limiting method in which, in an electricity storage system including a load and multiple electricity storage units connected to the load, a maximum amount of electric power that is supplied to the load from the electricity storage units is limited. Each of the electricity storage units includes a battery pack that is connected to the load and includes multiple battery cells, and a contactor provided between the battery pack and the load. The limiting method includes a determination step of determining whether an abnormality has occurred in the electricity storage unit, and a supply limiting step of limiting, when it is determined in the determination step that an abnormality has occurred in the electricity storage unit, the maximum amount of electric power that is supplied to the load in a stepwise manner in accordance with a level of the abnormality of the electricity storage unit.

### BRIEF DESCRIPTION OF THE DRAWINGS

FIG. 1 is a schematic view illustrating an electricity storage system.
FIG. 2 is a block diagram of the electricity storage system.
FIG. 3 is a diagram illustrating types of abnormalities of an electricity storage unit.
FIG. 4 is a chart illustrating thresholds with a reference upper limit voltage value used as a reference.
FIG. 5 is a chart illustrating thresholds with a reference lower limit voltage value used as a reference.
FIG. 6 is a flowchart illustrating steps of detection of an abnormality of the electricity storage unit.
FIG. 7 is a chart illustrating thresholds with a reference upper limit temperature used as a reference.

### DETAILED DESCRIPTION OF THE PREFERRED EMBODIMENTS

Preferred embodiments of a technology disclosed herein will be described below with reference to the accompanying drawings. As a matter of course, the preferred embodiments described herein are not intended to be particularly limiting the present disclosure. The accompanying drawings are schematic and do not necessarily reflect actual members or portions. Members/portions that have the same effect will be denoted by the same sign as appropriate, and the overlapping description will be omitted as appropriate.

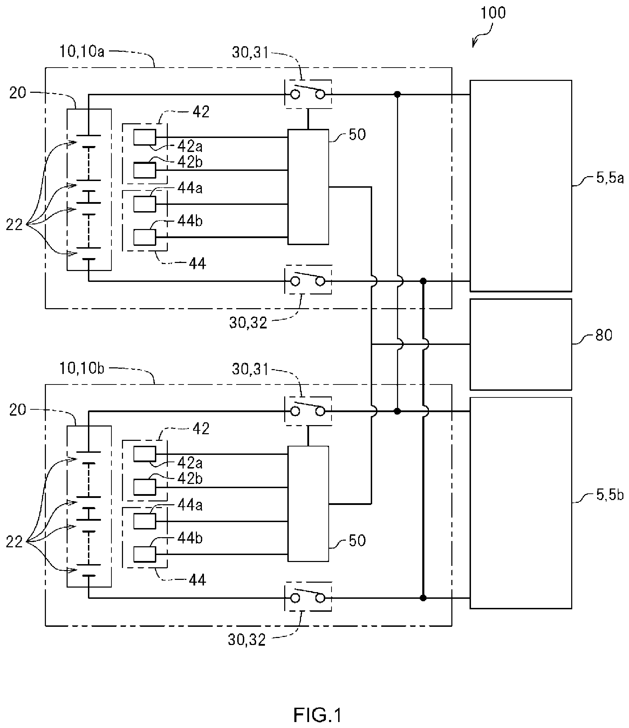

FIG. 1 is a schematic view illustrating an electricity storage system 100 according to this preferred embodiment. As illustrated in FIG. 1, the electricity storage system 100 includes a load 5 and multiple electricity storage units 10. In the electricity storage system 100, the multiple electricity storage units 10 is used as a power source that supplies electric power to the load 5. There is no particular limitation on a type of the load 5. In this preferred embodiment, the load 5 is, for example, a drive device, such as an electric motor of a vehicle, or the like, an inverter, or the like. A smoothing capacitor that reduces a rapid change of a current may be connected to the load 5. In this preferred embodiment, the electricity storage system 100 includes two loads 5, that is, a first load 5a and a second load 5b. However, the number of the loads 5 is three or more, and may be one. When the electricity storage system 100 includes one load 5, one of the first load 5a and the second load 5b may be omitted.

In this preferred embodiment, the electricity storage system 100 is mounted on a vehicle. The load 5 can be an electric motor that causes the vehicle to travel. Although there is no particular limitation on a specific type of the vehicle, the specific types of the vehicle include a vessel. The vessel can be in a state where the vessel floats on water at all times, and therefore, hypothetically even when a malfunction occurs in the electricity storage system 100, the load 5 is preferably in a state where the load 5 operates as much as possible. Therefore, the multiple loads 5 (for example, the first load 5a and the second load 5b) can be mounted on the vessel. Hypothetically even when a malfunction occurs in the first load 5a, the vessel can be operated by the second load 5b. Note that the vehicle on which the electricity storage system 100 is mounted is not limited to a vessel, and may be, for example, an automobile, such as a hybrid electric vehicle, a plug-in hybrid electric vehicle, an electric vehicle, or the like. The electricity storage system 100 is not limited to vehicle applications.

The multiple electricity storage units 10 are connected in parallel. Although there is no particular limitation on the number of the electricity storage units 10, herein, the number of the electricity storage units 10 is two. The number of the electricity storage units 10 may be three or more. The electricity storage unit 10 includes a first electricity storage unit 10a and a second electricity storage unit 10b. The multiple electricity storage units 10 (herein, the first electricity storage unit 10a and the second electricity storage unit 10b) are connected in parallel. Each of the electricity storage units 10 is connected to the loads 5, specifically, is connected to the first load 5a and the second load 5b. That is, the first electricity storage unit 10a is connected to the first load 5a and the second load 5b. The second electricity storage unit 10b is connected to the first load 5a and the second load 5b.

Note that the first electricity storage unit 10a and the second electricity storage unit 10b have the same configuration. In the following description, for the first electricity storage unit 10a and the second electricity storage unit 10b, a wording of "electricity storage unit 10" is used for common description. In this preferred embodiment, as illustrated in FIG. 1, each of the electricity storage units 10 includes a battery pack 20, a contactor 30, and a controller 50.

The battery pack 20 is connected to the load 5 (herein, both of the first load 5a and the second load 5b). The battery pack 20 includes multiple battery cells 22. The battery cells 22 can be charged and discharged. As the battery cells 22, for example, secondary batteries that can be repeatedly charged and discharged by moving of charge carriers between a pair of electrodes (for example, a positive electrode and a negative electrode) via an electrolyte can be used. As the battery cells 22, for example, lithium-ion secondary batteries, nickel-hydrogen batteries, or the like can be used. Herein, an example where, as the battery cells 22, lithium-ion secondary batteries are used will be described. In this preferred embodiment, the multiple battery cells 22 are connected in series. Herein, the multiple battery cells 22 are connected in series via an unillustrated bus bar. However, the multiple battery cells 22 may be connected in parallel. There is no particular limitation on the number of the battery cells 22 included in one battery pack 20, and the number of the battery cells 22 is a preset number. In this preferred embodiment, the number of the battery cells 22 included in the battery pack 20 of the first electricity storage unit 10a and the number of the battery cells 22 included in the battery pack 20 of the second electricity storage unit 10b are the same, but may be different.

The contactor 30 is provided between the battery pack 20 and the load 5 (herein, each of the first load 5a and the second load 5b). The contactor 30 is connected to the battery pack 20 (in other words, the multiple battery cells 22 connected in series) in series. The contactor 30 switches connection of the battery pack 20 and the load 5 between on and off. As used herein, the term "contactor" is referred to as a relay in other words. In this preferred embodiment, the contactor 30 includes a first contactor 31 and a second contactor 32. The first contactor 31 is connected to an end portion of the battery pack 20 at a positive electrode side in series. The first contactor 31 switches connection of a terminal of the battery pack 20 at the positive electrode side and the load 5 between on and off. The second contactor 32 is connected to an end portion of the battery pack 20 at a negative electrode side in series. The second contactor 32 switches connection of a terminal of the battery pack 20 at the negative electrode side and the load 5 between on and off. Note that, in this preferred embodiment, the expression "turn on the contactor 30" refers to causing a connected state (close state). The expression "turn off the contactor 30" refers to causing a disconnected state (open state). In this preferred embodiment, in the contactor 30 including the first contactor 31 and the second contactor 32, on and off are electrically switched around.

In this preferred embodiment, as illustrated in FIG. 1, the electricity storage unit 10 includes a voltage sensor 42 and a temperature sensor 44. The voltage sensor 42 detects a voltage value of the battery pack 20. Herein, the voltage sensor 42 may be configured to detect a voltage value of the entire battery pack 20, and may be configured to detect a voltage value of each of the multiple battery cells 22 included in the battery pack 20 to detect the voltage value of the battery pack 20 from the voltage values of the battery cells 22. Note that there is no particular limitation on the number of voltage sensors 42 provided in each of the electricity storage units 10. Herein, the voltage sensor 42 includes a main voltage sensor 42a and a sub voltage sensor 42b, and thus, two voltage sensors 42 are provided in each of the electricity storage units 10. The main voltage sensor 42a and the sub voltage sensor 42b can detect voltages at an approximately same portion. In each of the electricity storage units 10, when it is normal, the voltages detected by the main voltage sensor 42a and the sub voltage sensor 42b can be at an approximately same value (for example, within a predetermined voltage allowable range).

The temperature sensor 44 detects a temperature of the battery pack 20 (for example, a surface temperature of the battery pack 20). The temperature sensor 44 may be configured to detect, for example, a temperature of each of the multiple battery cells 22 included in the battery pack 20 to detect the temperature of the battery pack 20 from the temperatures of the battery cells 22. The temperature sensor 44 may be configured to detect, for example, an average for the temperatures of the battery cells 22 as the temperature of the battery pack 20. Note that there is no particular limitation on the number of the temperature sensors 44 provided in each of the electricity storage units 10. Herein, as illustrated in FIG. 1, the temperature sensor 44 includes a main temperature sensor 44a and a sub temperature sensor 44b, and thus, two temperature sensors 44 are provided in each of the electricity storage units 10. The main temperature sensor 44a and the sub temperature sensor 44b can detect temperatures at an approximately same portion. In each of the electricity storage units 10, when it is normal, the temperatures detected by the main temperature sensor 44a and the sub temperature sensor 44b can be at an approximately same value (for example, within a predetermined temperature allowable range).

The controller 50 monitors a state of the battery pack 20 and controls charging and discharging of the battery pack 20. The controller 50 detects an abnormality of the electricity storage unit 10 and performs control to limit electric power that is supplied to the load 5 in a stepwise manner in accordance with a level of the abnormality of the electricity storage unit 10. There is no particular limitation on a configuration of the controller 50. The controller 50 is, for example, a microcomputer. The controller 50 incudes, for example, an I/F, a CPU, a ROM, or a RAM. The controller 50 may be configured of a single computer, and may be configured of multiple computers.

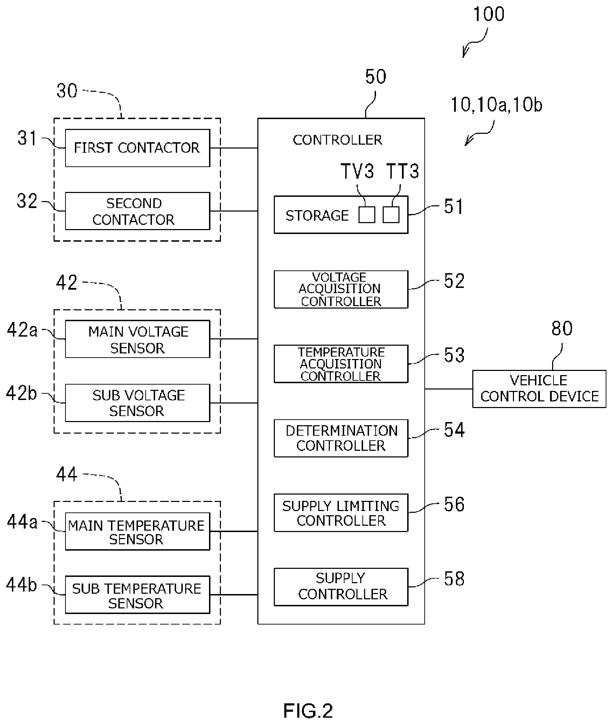

FIG. 2 is a block diagram of the electricity storage system 100. In this preferred embodiment, as illustrated in FIG. 2, the controller 50 is communicably connected to the contactor 30 (specifically, the first contactor 31 and the second contactor 32), the voltage sensor 42 (specifically, the main voltage sensor 42a and the sub voltage sensor 42b), and the temperature sensor 44 (specifically, the main temperature sensor 44a and the sub temperature sensor 44b). The controller 50 controls switching the contactor 30 between on and off. The controller 50 acquires the voltage value of the battery pack 20 from the voltage sensor 42. The controller 50 acquires the temperature of the battery pack 20 from the temperature sensor 44. In this preferred embodiment, the electricity storage system 100 is a system mounted on a vehicle. Therefore, the controller 50 is communicably connected to a vehicle control device 80 (for example, an engine control unit (ECU)) that performs control of the entire vehicle (for example, control of a drive device, such as an electric motor or the like, during driving).

In this preferred embodiment, as illustrated in FIG. 2, the controller 50 includes a storage 51, a voltage acquisition controller 52, a temperature acquisition controller 53, a determination controller 54, a supply limiting controller 56, and a supply controller 58. Each of the controllers 52 to 58 may be realized by one or more processors, and may be realized by a circuit. Note that a specific feature of each of the controllers 52 to 58 will be described later.

A configuration of the electricity storage system 100 according to this preferred embodiment has been described above. Incidentally, as illustrated in FIG. 1, in the electricity storage system 100 in which the multiple electricity storage units 10 are connected in parallel, an abnormality can occur in each of the electricity storage units 10. For example, when an abnormality occurs in the first electricity storage unit 10a, electric power that is supplied to the load 5 from the first electricity storage unit 10a can be limited. Hypothetically, when an abnormality occurs in the first electricity storage unit 10a and supply of electric power to the load 5 from the first electricity storage unit 10a is cut off, electric power is supplied to the load 5 from the second electricity storage unit 10b, and therefore, the load 5 can be driven.

In this preferred embodiment, in order to detect an abnormality of the electricity storage unit 10, in each of the electricity storage units 10, the controller 50 has a monitoring function of monitoring a state of the battery pack 20 on a regular basis. For example, the controller 50 determines, based on the voltage value of the battery pack 20 detected by the voltage sensor 42 or the temperature of the battery pack 20 detected by the temperature sensor 44, whether an abnormality has occurred in the electricity storage unit 10. When an abnormality has occurred in the electricity storage unit 10, a maximum supply amount of electric power to the load 5 by the electricity storage unit 10 is limited.

Incidentally, there can be multiple types of abnormalities of the electricity storage units 10. Depending on the types of abnormalities, there can be a case where supply of electric power from the electricity storage units 10 may not be cut off. Therefore, in this preferred embodiment, when an abnormality occurs in any one of the electricity storage unit 10, depending on a type of the abnormality, a supply amount of electric power to the load 5 from the electricity storage unit 10 is limited. Herein, the supply limiting controller 56 of FIG. 2 limits a maximum amount of electric power that is supplied to the load 5 in a stepwise manner in accordance with the level of the abnormality of the electricity storage unit 10.

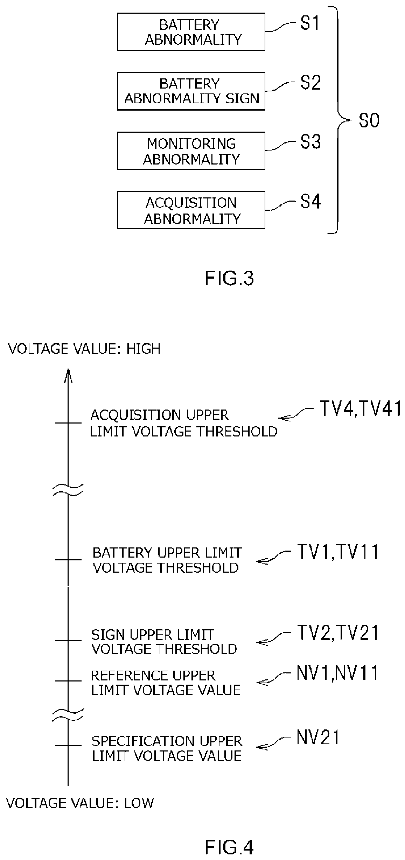

FIG. 3 is a diagram illustrating types of an abnormality S0 of the electricity storage unit 10. In this preferred embodiment, as illustrated in FIG. 3, the types of the abnormality S0 of the electricity storage unit 10 include a battery abnormality S1, a battery abnormality sign S2, a monitoring abnormality S3, and an acquisition abnormality S4. The battery abnormality S1 is an abnormality of the battery pack 20. The battery abnormality S1 includes an overcharge abnormality, an overdischarge abnormality, and an excessive temperature rise abnormality. The overcharge abnormality refers to a state where the battery pack 20 is overcharged. The overdischarge abnormality refers to a state where the battery pack 20 is overdischarged. The excessive temperature rise abnormality refers to a state where the temperature of the battery pack 20 has excessively risen.

The battery abnormality sign S2 refers to a state of the battery pack 20 where it is highly likely that the battery pack 20 will have the battery abnormality S1. That is, the battery abnormality sign S2 refers to a state of the battery pack 20 where it is highly likely that the battery pack 20 will have the overcharge abnormality, a state of the battery pack 20 where it is highly likely that the battery pack 20 will have the overdischrage abnormality, or a state of the battery pack 20 where it is highly likely that the battery pack 20 will have the excessive temperature rise abnormality.

The monitoring abnormality S3 is an abnormality of the monitoring function of the electricity storage unit 10. The monitoring abnormality S3 is an abnormality of the electricity storage unit 10 other than the battery pack 20. For example, a state where the battery pack 20 is actually not in a state of the battery abnormality S1 but in a state where it can be determined because of an abnormality of the monitoring function that the battery pack 20 has an abnormality is the monitoring abnormality S3. The monitoring abnormality S3 is, for example, an abnormality of a substrate or the like that realizes the controller 50. The acquisition abnormality S4 is an abnormality for a function related to monitoring or acquisition of the voltage value of the battery pack 20 from the voltage sensor 42 and an abnormality for a function related to monitoring or acquisition of the temperature of the battery pack 20 from the temperature sensor 44. For example, when the voltage value cannot be acquired from the voltage sensor 42 and when the temperature of the battery pack 20 cannot be acquired from the temperature sensor 44, there is the acquisition abnormality S4. The acquisition abnormality S4 is an abnormality that occurs when the state of the battery pack 20 is monitored by the monitoring function on a regular basis.

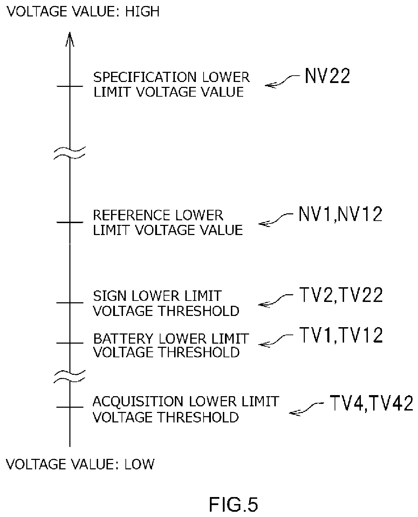

In this preferred embodiment, as a parameter used for determining whether the electricity storage unit 10 has an abnormality, the voltage value of the battery pack 20 detected by the voltage sensor 42 or the temperature of the battery pack 20 detected by the temperature sensor 44 is used. Herein, first, an abnormality detection method for the electricity storage unit 10 using the voltage sensor 42 will be described. FIG. 4 is a chart illustrating thresholds with a reference upper limit voltage value NV11 used as a reference. FIG. 5 is a chart illustrating thresholds with a reference lower limit voltage value NV12 used as a reference. In this preferred embodiment, in the electricity storage system 100, as illustrated in FIG. 4 and FIG. 5, a preset reference voltage value NV1 is set. The reference voltage value NV1 includes the reference upper limit voltage value NV11 (see FIG. 4) and the reference lower limit voltage value NV12 (see FIG. 5). The reference upper limit voltage value NV11 illustrated in FIG. 4 is, for example, the voltage value of the battery pack 20 when SOC of the battery pack 20 is 100%. As used herein, the term "SOC" is an abbreviation of state of charge, and refers to a change state of the battery pack 20. SOC refers to, for example, a battery capacity that is 100% in a fully charged state and is 0% in a completely discharged state. The SOC of the battery pack 20 refers to the battery capacity of the multiple battery cells 22 that form the battery pack 20 as a whole. The reference lower limit voltage value NV12 illustrated in FIG. 5 is, for example, the voltage value of the battery pack 20 when the SOC of the battery pack 20 is 0 %

Note that, herein, a specification upper limit voltage value NV21 (see FIG. 4) and a specification lower limit voltage value NV22 (see FIG. 5) are set for the battery pack 20 in advance. The specification upper limit voltage value NV21 is the voltage value of the battery pack 20 that is an upper limit in a specification when the battery pack 20 is normally used. The specification upper limit voltage value NV21 is the voltage value of the battery pack 20, for example, when the battery pack 20 has a specific upper limit SOC that is a SOC serving as an upper limit for the battery pack 20 when the battery pack 20 is normally used. The specification lower limit voltage value NV22 is the voltage value of the battery pack 20 that is a lower limit in a specification when the battery pack 20 is normally used. The specification lower limit voltage value NV22 is the voltage value of the battery pack 20, for example, when the battery pack 20 has a specific lower limit SOC that is a SOC serving as a lower limit for the battery pack 20 when the battery pack 20 is normally used. Herein, as illustrated in FIG. 4, the reference upper limit voltage value NV11 is a higher value than the specification upper limit voltage value NV21. As illustrated in FIG. 5, the reference lower limit voltage value NV12 is a lower value than the specification lower limit voltage value NV22.

In this preferred embodiment, as illustrated in FIG. 4 and FIG. 5, with the reference voltage value NV1 used as a reference, a battery voltage threshold TV1 used for detecting the battery abnormality S1, a sign voltage threshold TV2 used for detecting the battery abnormality sign S2, and an acquisition voltage threshold TV4 used for detecting the acquisition abnormality S4 are set. The battery voltage threshold TV1 includes a battery upper limit voltage threshold TV11 (see FIG. 4) and a battery lower limit voltage threshold TV12 (see FIG. 5). The battery upper limit voltage threshold TV11 is an upper limit voltage value of the battery pack 20 when the battery abnormality S1 is detected. As illustrated in FIG. 4, the battery upper limit voltage threshold TV11 is set with the reference upper limit voltage value NV11 used as a reference. Herein, the battery upper limit voltage threshold TV11 is a higher value than the reference upper limit voltage value NV11. The battery lower limit voltage threshold TV12 is a lower limit voltage value of the battery pack 20 when the battery abnormality S1 is detected. As illustrated in FIG. 5, the battery lower limit voltage threshold TV12 is set with the reference lower limit voltage value NV12 used as a reference. Herein, the battery lower limit voltage threshold TV12 is a lower value than the reference lower limit voltage value NV12.

The sign voltage threshold TV2 includes a sign upper limit voltage threshold TV21 (see FIG. 4) and a sign lower limit voltage threshold TV22 (see FIG. 5). The sign upper limit voltage threshold TV21 is an upper limit voltage value of the battery pack 20 when the battery abnormality sign S2 is detected. As illustrated in FIG. 4, the sign upper limit voltage threshold TV21 is set with the reference upper limit voltage value NV11 used as a reference. Herein, the sign upper limit voltage threshold TV21 is a higher value than the reference upper limit voltage value NV11 and a lower value than the battery upper limit voltage threshold TV11. The sign lower limit voltage threshold TV22 is a lower limit voltage value of the battery pack 20 when the battery abnormality sign S2 is detected. As illustrated in FIG. 5, the sign lower limit voltage threshold TV22 is set with the reference lower limit voltage value NV12 used as a reference. Herein, the sign lower limit voltage threshold TV22 is a lower value than the reference lower limit voltage value NV12 and a higher value than the battery lower limit voltage threshold TV12.

The acquisition voltage threshold TV4 includes an acquisition upper limit voltage threshold TV41 (see FIG. 4) and an acquisition lower limit voltage threshold TV42 (see FIG. 5). The acquisition upper limit voltage threshold TV41 is an upper limit voltage value of the battery pack 20 when the acquisition abnormality S4 is detected. As illustrated in FIG. 4, the acquisition upper limit voltage threshold TV41 is set with the reference upper limit voltage value NV11 used as a reference. Herein, the acquisition upper limit voltage threshold TV41 is a higher value than the reference upper limit voltage value NV11 and a higher value than the battery upper limit voltage threshold TV11 and the sign upper limit voltage threshold TV21. The acquisition lower limit voltage threshold TV42 is a lower limit voltage value of the battery pack 20 when the acquisition abnormality S4 is detected. As illustrated in FIG. 5, the acquisition lower limit voltage threshold TV42 is set with the reference lower limit voltage value NV12 used as a reference. Herein, the acquisition lower limit voltage threshold TV42 is a lower value than the reference lower limit voltage value NV12 and a lower value than the battery lower limit voltage threshold TV12 and the sign lower limit voltage threshold TV22.

Note that, in this preferred embodiment, there no particular limitation on specific values of the reference upper limit voltage value NV11, the sign upper limit voltage threshold TV21, the battery upper limit voltage threshold TV11, and the acquisition upper limit voltage threshold TV41. For example, the reference upper limit voltage value NV11, the sign upper limit voltage threshold TV21, the battery upper limit voltage threshold TV11, and the acquisition upper limit voltage threshold TV41 are 4.20 V, 4.25V, 4.35 V, and 4.98 V, respectively. There is no particular limitation on specific values of the reference lower limit voltage value NV12, the sign lower limit voltage threshold TV22, the battery lower limit voltage threshold TV12, and the acquisition lower limit voltage threshold TV42. For example, the reference lower limit voltage value NV12, the sign lower limit voltage threshold TV22, the battery lower limit voltage threshold TV12, and the acquisition lower limit voltage threshold TV42 are 3.00 V, 2.50 V, 1.90 V, and 0.10 V, respectively.

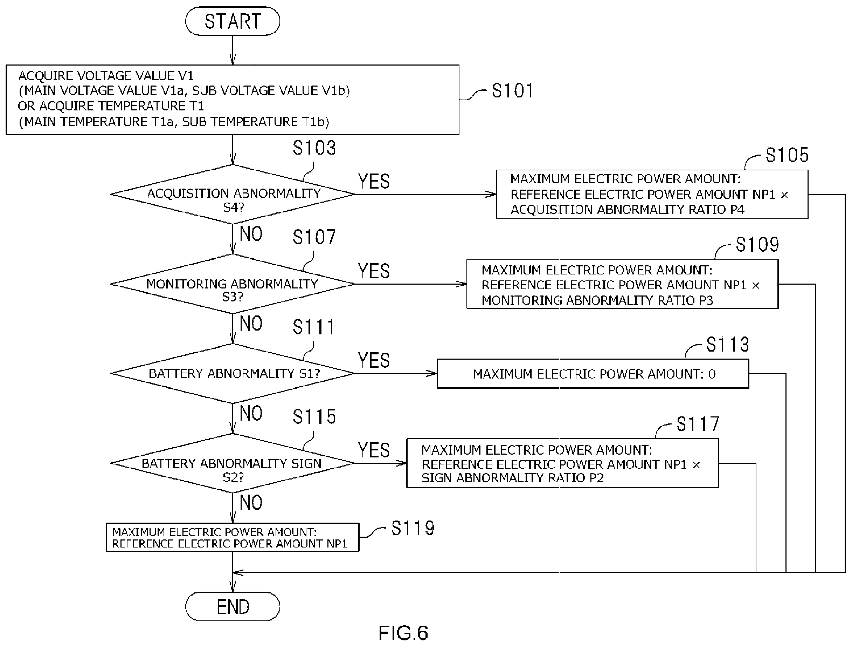

Next, steps for detecting an abnormality of the electricity storage unit 10 using the voltage of the battery pack 20 will be described in accordance with a flowchart of FIG. 6. In the following description, steps for detecting an abnormality in one of the multiple electricity storage units 10 will be described, but in an actual situation, detection of an abnormality is performed on each of the multiple electricity storage units 10.

First, in Step S101 of FIG. 6, the voltage acquisition controller 52 of FIG. 2 acquires a voltage value V1 of the battery pack 20 of the electricity storage unit 10. Herein, the voltage acquisition controller 52 acquires the voltage value V1 of the battery pack 20 from the voltage sensor 42. In this preferred embodiment, as illustrated in FIG. 1, as the voltage sensor 42, two sensors, that is, the main voltage sensor 42a and the sub voltage sensor 42b, are used. Therefore, the voltage acquisition controller 52 acquires the voltage value V1 of the battery pack 20 from both of the main voltage sensor 42a and the sub voltage sensor 42b. Herein, for example, a voltage acquisition signal is transmitted from the voltage acquisition controller 52 to the voltage sensor 42. The voltage sensor 42 (herein, the main voltage sensor 42a and the sub voltage sensor 42b) that has acquired the voltage acquisition signal detects the voltage value V1 of the battery pack 20. Each of the main voltage sensor 42a and the sub voltage sensor 42b transmits the detected voltage value V1 to the controller 50. Thereafter, the voltage acquisition controller 52 acquires the voltage value V1 transmitted from each of the main voltage sensor 42a and the sub voltage sensor 42b. Note that the voltage value V1 of the battery pack 20 acquired by the voltage acquisition controller 52 is stored in the storage 51. In the following description, the voltage value V1 detected by the main voltage sensor 42a will be also referred to as a main voltage value V1a. The voltage value V1 detected by the sub voltage sensor 42b will be also referred to as a sub voltage value V1b.

Note that, in this preferred embodiment, although the voltage acquisition controller 52 is configured to acquire the voltage value V1 of the battery pack 20, there can be a case where the voltage acquisition controller 52 cannot acquire the voltage value V1. For example, even when a preset determination time has elapsed since the voltage acquisition signal was transmitted as described above, the voltage value V1 of the battery pack 20 is not acquired in some cases. In this case, the determination controller 54 of FIG. 2 may determine that a communication abnormality has occurred in the voltage sensor 42 of the electricity storage unit 10. In this preferred embodiment, the communication abnormality of the voltage sensor 42 can be included in the monitoring abnormality S3 (see FIG. 3). When it is determined by the determination controller 54 that a communication abnormality has occurred in the voltage sensor 42 of the electricity storage unit 10, it may be assumed that the electricity storage unit 10 has the monitoring abnormality S3 and Step S109 (see FIG. 6) that will be described later may be executed next.

When the voltage value V1 of the battery pack 20 is acquired by the voltage acquisition controller 52 in Step S101, the process proceeds to Step S103 of FIG. 6. In Step S103, the determination controller 54 of FIG. 2 determines whether the electricity storage unit 10 has the acquisition abnormality S4. Herein, it is determined by comparing the voltage value V1 of the battery pack 20 with the acquisition voltage threshold TV4 (see FIG. 4 and FIG. 5) whether the electricity storage unit 10 has the acquisition abnormality S4. In this preferred embodiment, the determination controller 54 determines whether the voltage value V1 (herein, the main voltage value V1a and the sub voltage value V1b) of the battery pack 20 acquired by the voltage acquisition controller 52 is equal to or more than the acquisition upper limit voltage threshold TV41 illustrated in FIG. 4, and determines whether the voltage value V1 of the battery pack 20 is equal to or less than the acquisition lower limit voltage threshold TV42 illustrated in FIG. 5. Then, when at least one of the main voltage value V1a and the sub voltage value V1b is equal to or more than the acquisition upper limit voltage threshold TV41 or is equal to or lower than the acquisition lower limit voltage threshold TV42, the determination controller 54 determines that the electricity storage unit 10 has the acquisition abnormality S4. When it is determined that the electricity storage unit 10 has the acquisition abnormality S4, the process proceeds to Step S105 of FIG. 6 next.

In Step S105, the supply limiting controller 56 of FIG. 2 limits the maximum amount of electric power that is supplied to the load 5. For example, when the electricity storage unit 10 is normal, the maximum amount of electric power that is supplied to the load 5 from the electricity storage unit 10 is a reference electric power amount NP1. The reference electric power amount NP1 can be changed in accordance with the SOC or the temperature of the battery pack 20. When it is determined that the electricity storage unit 10 has the acquisition abnormality S4, the supply limiting controller 56 limits the maximum amount of electric power that is supplied to the load 5 to a maximum amount of electric power that corresponds to a preset acquisition abnormality ratio P4 with respect to the reference electric power amount NP1. That is, when the electricity storage unit 10 has the acquisition abnormality S4, the maximum amount of electricity power that is supplied to the load 5 is limited to the reference electric power amount NP1 × the acquisition abnormality ratio P4. When the electricity storage unit 10 has the acquisition abnormality S4, the supply limiting controller 56 maintains the contactor 30 (herein, the first contactor 31 and the second contactor 32) of the electricity storage unit 10 on, that is, a close state that is a connected state. There is no particular limitation on a specific numerical value of the acquisition abnormality ratio P4, but the acquisition abnormality ratio P4 is, for example, 50%.

On the other hand, in Step S103 of FIG. 6, each of both the main voltage value V1a and the sub voltage value V1b is less than the acquisition upper limit voltage threshold TV41 and is larger than the acquisition lower limit voltage threshold TV42, the determination controller 54 determines that the electricity storage unit 10 does not have the acquisition abnormality S4. When it is determined that the electricity storage unit 10 does not have the acquisition abnormality S4, the process proceeds to Step S107 of FIG. 6 next. In Step S107, the determination controller 54 determines whether the electricity storage unit 10 has the monitoring abnormality S3. Herein, the determination controller 54 determines whether a difference between the main voltage value V1a and the sub voltage value V1b is equal to or more than a preset monitoring voltage threshold TV3 (see FIG. 2). The monitoring voltage threshold TV3 is stored in the storage 51 in advance. For example, when the difference between the main voltage value V1a and the sub voltage value V1b is equal to or more than the monitoring voltage threshold TV3, which the main voltage value V1a or the sub voltage value V1b is an accurate voltage value of the battery pack 20 is not known. In this case, the determination controller 54 determines that the electricity storage unit 10 has the monitoring abnormality S3. When it is determined that the electricity storage unit 10 has the monitoring abnormality S3, the process proceeds to Step S109 of FIG. 6 next.

In Step S109, the supply limiting controller 56 of FIG. 2 limits the maximum amount of electric power that is supplied to the load 5 when the electricity storage unit 10 has the monitoring abnormality S3. When it is determined that the electricity storage unit 10 has the monitoring abnormality S3, the supply limiting controller 56 limits the maximum amount of electric power that is supplied to the load 5 to a maximum amount of electric power that corresponds to the preset monitoring abnormality ratio P3 with respect to the reference electric power amount NP1. That is, when the electricity storage unit 10 has the monitoring abnormality S3, the maximum amount of electric power that is supplied to the load 5 is limited to the reference electric power amount NP1 × the monitoring abnormality ratio P3. When the electricity storage unit 10 has the monitoring abnormality S3, the supply limiting controller 56 maintains the contactor 30 (herein, the first contactor 31 and the second contactor 32) of the electricity storage unit 10 on, that is, a close state that is a connected state. Herein, the monitoring abnormality ratio P3 is a smaller ratio than the acquisition abnormality ratio P4. There is no particular limitation on a specific numerical value of the monitoring abnormality ratio P3, but the monitoring abnormality ratio P3 is, for example, 30%. When the electricity storage unit 10 has the monitoring abnormality S3 described above, an open request to put the contactor 30 in an open state may be issued.

On the other hand, in Step S107 of FIG. 6, when the difference between the main voltage value V1a and the sub voltage value V1b is less than the monitoring voltage threshold TV3, the difference between the main voltage value V1a and the sub voltage value V1b is small and both of the voltage values are correct. In this case, the determination controller 54 determines that the electricity storage unit 10 does not have the monitoring abnormality S3. When it is determined that the electricity storage unit 10 does not have the monitoring abnormality S3, the process proceeds to Step S111 of FIG. 6 next. In Step S111, the determination controller 54 of FIG. 2 determines whether the electricity storage unit 10 has the battery abnormality S1. Herein, whether the electricity storage unit 10 has the battery abnormality S1 is determined by comparing the voltage value V1 of the battery pack 20 with the battery voltage threshold TV1 (see FIG. 4 and FIG. 5). In this preferred embodiment, the determination controller 54 determines whether the voltage value V1 (herein, the main voltage value V1a and the sub voltage value V1b) of the battery pack 20 acquired by the voltage acquisition controller 52 is equal to or more than the battery upper limit voltage threshold TV11 (see FIG. 4) and determines whether the voltage value V1 of the battery pack 20 is equal to or less than the battery lower limit voltage threshold TV12 (see FIG. 5). Then, when at least one of the main voltage value V1a and the sub voltage value V1b is equal to or more than the battery upper limit voltage threshold TV11 or equal to or less than the battery lower limit voltage threshold TV12, the determination controller 54 determines that the electricity storage unit 10 has the battery abnormality S1. When it is determined that the electricity storage unit 10 has the battery abnormality S1, the process proceeds to Step S113 of FIG. 6 next.

In Step S113, the supply limiting controller 56 of FIG. 2 limits the maximum amount of electric power that is supplied to the load 5 when the electricity storage unit 10 has the battery abnormality S1. Herein, since an abnormality has occurred in the battery pack 20, it is caused not to supply electric power to the load 5, that is, the supply limiting controller 56 limits the maximum amount of electric power that is supplied to the load 5 to 0. In this preferred embodiment, as illustrated in FIG. 1, the supply limiting controller 56 controls the contactor 30 (herein, the first contactor 31 and the second contactor 32) of the electricity storage unit 10 to off, that is, an open state that is a disconnected state.

In Step S111 of FIG. 6, each of both the main voltage value V1a and the sub voltage value V1b is less than the battery upper limit voltage threshold TV11 and is larger than the battery lower limit voltage threshold TV12, the determination controller 54 determines that the electricity storage unit 10 does not have the battery abnormality S1. When it is determined that the electricity storage unit 10 does not have the battery abnormality S1, the process proceeds to Step S115 of FIG. 6 next. In Step S115, the determination controller 54 of FIG. 2 determines whether the electricity storage unit 10 has the battery abnormality sign S2. Herein, it is determined by comparing the voltage value V1 of the battery pack 20 with the sign voltage threshold TV2 (see FIG. 4 and FIG. 5) whether the electricity storage unit 10 has the battery abnormality sign S2. In this preferred embodiment, the determination controller 54 determines whether the voltage value V1 (herein, the main voltage value V1a and the sub voltage value V1b) of the battery pack 20 acquired by the voltage acquisition controller 52 is equal to or more than the sign upper limit voltage threshold TV21 (see FIG. 4) and determines whether the voltage value V1 of the battery pack 20 is equal to or less than the sign lower limit voltage threshold TV22 (see FIG. 5). Then, when at least one of the main voltage value V1a and the sub voltage value V1b is equal to or more than the sign upper limit voltage threshold TV21 or is equal to or less than the sign lower limit voltage threshold TV22, the determination controller 54 determines that the electricity storage unit 10 has the battery abnormality sign S2. When it is determined that the electricity storage unit 10 has the battery abnormality sign S2, the process proceeds to Step S117 of FIG. 6.

In Step S117, the supply limiting controller 56 of FIG. 2 limits the maximum amount of electric power that is supplied to the load 5 when the electricity storage unit 10 has the battery abnormality sign S2. When it is determined that the electricity storage unit 10 has the battery abnormality sign S2, the supply limiting controller 56 limits the maximum amount of electric power that is supplied to the load 5 to a maximum amount of electric power that corresponds to a preset sign abnormality ratio P2 with respect to the reference electric power amount NP1. That is, when the electricity storage unit 10 has the battery abnormality sign S2, the maximum amount of electric power that is supplied to the load 5 is limited to the reference electric power amount NP1 × the sign abnormality ratio P2. When the electricity storage unit 10 has the battery abnormality sign S2, the supply limiting controller 56 maintains the contactor 30 (herein, the first contactor 31 and the second contactor 32) of the electricity storage unit 10 on, that is, a close state that is a connected state.

In Step S115 of FIG. 6, when each of both the main voltage value V1a and the sub voltage value V1b is less than the sign upper limit voltage threshold TV21 and is larger than the sign lower limit voltage threshold TV22, the determination controller 54 determines that the electricity storage unit 10 does not have the battery abnormality sign S2. In this case, the determination controller 54 determines that an abnormality has not occurred in the electricity storage unit 10 and the electricity storage unit 10 is normal. When it is determined that the electricity storage unit 10 is normal, the process proceeds to Step S119 of FIG. 6 next. In Step S119, the supply controller 58 of FIG. 2 does not limit the maximum amount of electric power that is supplied to the load 5. That is, when the electricity storage unit 10 is normal, the supply controller 58 controls the maximum amount of electric power that is supplied to the load 5 to the reference electric power amount NP1. When the electricity storage unit 10 is normal, the supply controller 58 maintains the contactor 30 (herein, the first contactor 31 and the second contactor 32) of the electricity storage unit 10 on, that is, a close state that is a connected state. In the above-described manner, determination on an abnormality of the electricity storage unit 10 can be performed using the voltage value V1 of the battery pack 20 in accordance with the flowchart of FIG. 6.

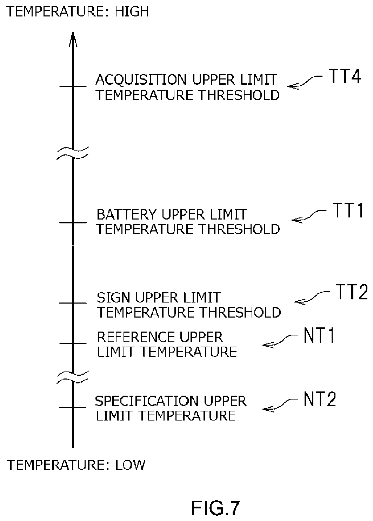

Note that, in this preferred embodiment, an abnormality of the electricity storage unit 10 can be detected based on the temperature of the battery pack 20. Next, a method for detecting an abnormality of the electricity storage unit 10 using the temperature sensor 44 will be described. FIG. 7 is a chart illustrating thresholds with a reference upper limit temperature NT1 used as a reference. In this preferred embodiment, in the electricity storage system 100, as illustrated in FIG. 7, the preset reference upper limit temperature NT1 and a specification upper limit temperature NT2 are set. The reference upper limit temperature NT1 is a value that is a reference for the temperature of the battery pack 20 used for detecting an abnormality of the electricity storage unit 10. The specification upper limit temperature NT2 is the temperature of the battery pack 20 that is an upper limit in a specification when the battery pack 20 is normally used. Herein, the reference upper limit temperature NT1 is a higher value than the specification upper limit temperature NT2.

In this preferred embodiment, a battery upper limit temperature threshold TT1 used for detecting the battery abnormality S1, a sign upper limit temperature threshold TT2 used for detecting the battery abnormality sign S2, and an acquisition upper limit temperature threshold TT4 used for detecting the acquisition abnormality S4 are set with the reference upper limit temperature NT1 used as a reference. The battery upper limit temperature threshold TT1 is an upper limit temperature of the battery pack 20 when the battery abnormality S1 is detected. The battery upper limit temperature threshold TT1 is set with the reference upper limit temperature NT1 used as a reference. Herein, the battery upper limit temperature threshold TT1 is a higher value than the reference upper limit temperature NT1.

The sign upper limit temperature threshold TT2 is an upper limit temperature of the battery pack 20 when the battery abnormality sign S2 is detected. The sign upper limit temperature threshold TT2 is set with the reference upper limit temperature NT1 used as a reference. Herein, the sign upper limit temperature threshold TT2 is a higher value than the reference upper limit temperature NT1 and a lower value than the battery upper limit temperature threshold TT1. The acquisition upper limit temperature threshold TT4 is an upper limit temperature of the battery pack 20 when the acquisition abnormality S4 is detected. The acquisition upper limit temperature threshold TT4 is set with the reference upper limit temperature NT1 used as a reference. Herein, the acquisition upper limit temperature threshold TT4 is a higher value than the reference upper limit temperature NT1 and is a higher value than the battery upper limit temperature threshold TT1 and the sign upper limit temperature threshold TT2.

Next, steps for detecting an abnormality of the electricity storage unit 10 using the temperature of the battery pack 20 will be described in accordance with the flowchart of FIG. 6 in a similar manner to steps performed when detecting an abnormality of the electricity storage unit 10 using the voltage value of the battery pack 20. Note that processing of each of Step S105, Step S109, Step S113, Step S117, and Step S119 is the same as processing of a corresponding one of the steps for detecting an abnormality of the electricity storage unit 10 using the voltage value V1 of the battery pack 20, and therefore, description thereof will be omitted.

First, in Step S101 of FIG. 6, the temperature acquisition controller 53 of FIG. 2 acquires a temperature T1 of the battery pack 20 of the electricity storage unit 10 is acquired. Herein, the temperature acquisition controller 53 acquires the temperature T1 of the battery pack 20 from the temperature sensor 44. In this preferred embodiment, as illustrated in FIG. 1, as the temperature sensor 44, two sensors, that is, the main temperature sensor 44a and the sub temperature sensor 44b, are used. Therefore, the temperature acquisition controller 53 acquires the temperature T1 of the battery pack 20 from both of the main temperature sensor 44a and the sub temperature sensor 44b. Herein, for example, a temperature acquisition signal is transmitted to the temperature sensor 44 from the temperature acquisition controller 53. The temperature sensor 44 (herein, the main temperature sensor 44a and the sub temperature sensor 44b) that has acquired the temperature acquisition signal detects the temperature T1 of the battery pack 20. Each of the main temperature sensor 44a and the sub temperature sensor 44b transmits the detected temperature T1 of the battery pack 20 to the controller 50. Thereafter, the temperature acquisition controller 53 acquires the temperature T1 of the battery pack 20 transmitted from each of the main temperature sensor 44a and the sub temperature sensor 44b. Note that the temperature T1 of the battery pack 20 acquired by the temperature acquisition controller 53 is stored in the storage 51 of FIG. 2. In the following description, the temperature detected by the main temperature sensor 44a will be also referred to as a main temperature T1a. The temperature detected by the sub temperature sensor 44b will be also referred to as a sub temperature T1b.

Note that, in this preferred embodiment, similar to the voltage acquisition controller 52, although the temperature acquisition controller 53 is configured to acquire the temperature T1 of the battery pack 20, there can be a case where the temperature acquisition controller 53 cannot acquire the temperature T1. For example, even when a preset determination time has elapsed since the temperature acquisition signal was transmitted as described above, the temperature T1 of the battery pack 20 is not acquired in some cases. In this case, the determination controller 54 of FIG. 2 may determine that a communication abnormality has occurred in the temperature sensor 44 of the electricity storage unit 10. In this preferred embodiment, as described above, when it is determined by the determination controller 54 that a communication abnormality has occurred in the temperature sensor 44 of the electricity storage unit 10, it may be assumed that the electricity storage unit 10 has the monitoring abnormality S3 and Step S109 of FIG. 6 may be executed next.

When the temperature T1 of the battery pack 20 is acquired by the temperature acquisition controller 53 in Step S101, the process proceeds to Step S103 of FIG. 6. In Step S103, the determination controller 54 of FIG. 2 determines whether the electricity storage unit 10 has the acquisition abnormality S4 by comparing the temperature T1 of the battery pack 20 with the acquisition upper limit temperature threshold TT4 (see FIG. 7). In this preferred embodiment, the determination controller 54 determines whether the temperature T1 (herein, the main temperature T1a and the sub temperature T1b) of the battery pack 20 acquired by the temperature acquisition controller 53 is equal to or more than the acquisition upper limit temperature threshold TT4. Then, when at least one of the main temperature T1a and the sub temperature T1b is equal to or more than the acquisition upper limit temperature threshold TT4, the determination controller 54 determines that the electricity storage unit 10 has the acquisition abnormality S4 and the process proceeds to Step S105 of FIG. 6.

On the other hand, in Step S103 of FIG. 6, each of both the main temperature T1a and the sub temperature T1b is less than the acquisition upper limit temperature threshold TT4, the determination controller 54 determines that the electricity storage unit 10 does not have the acquisition abnormality S4. When it is determined that the electricity storage unit 10 does not have the acquisition abnormality S4, the process proceeds to Step S107 of FIG. 6 next. In Step S107, the determination controller 54 determines whether a difference between the main temperature T1a and the sub temperature T1b is equal to or more than a preset monitoring temperature threshold TT3 (see FIG. 2). The monitoring temperature threshold TT3 is stored in the storage 51 in advance. For example, when the difference between the main temperature T1a and the sub temperature T1b is equal to or more than the monitoring temperature threshold TT3, which the main temperature T1a or the sub temperature T1b is an accurate temperature of the battery pack 20 is not known. In this case, the determination controller 54 determines that the electricity storage unit 10 has the monitoring abnormality S3. When it is determined that the electricity storage unit 10 has the monitoring abnormality S3, the process proceeds to Step S109 of FIG. 6 next.

On the other hand, in Step S107 of FIG. 6, when the difference between the main temperature T1a and the sub temperature T1b is less than the monitoring temperature threshold TT3, the difference between the main temperature T1a and the sub temperature T1b is small and both of the temperatures are correct. In this case, the determination controller 54 determines that the electricity storage unit 10 does not have the monitoring abnormality S3 and the process proceeds to Step S111 of FIG. 6. In Step S111, the determination controller 54 determines whether the electricity storage unit 10 has the battery abnormality S1 by comparing the temperature T1 of the battery pack 20 with the battery upper limit temperature threshold TT1 (see FIG. 7). In this preferred embodiment, the determination controller 54 determines whether the temperature T1 (herein, the main temperature T1a and the sub temperature T1b) of the battery pack 20 acquired by the temperature acquisition controller 53 is equal to or more than the battery upper limit temperature threshold TT1. Then, when at least one of the main temperature T1a and the sub temperature T1b is equal to or more than the battery upper limit temperature threshold TT1, the determination controller 54 determines that the electricity storage unit 10 has the battery abnormality S1 and the process proceeds to Step S113 of FIG. 6.

On the other hand, in Step S111 of FIG. 6, when each of both the main temperature T1a and the sub temperature T1b is less than the battery upper limit temperature threshold TT1, the determination controller 54 determines that the electricity storage unit 10 does not have the battery abnormality S1 and the process proceeds to Step S115 of FIG. 6. In Step S115, the determination controller 54 determines whether the battery pack 20 has the battery abnormality sign S2 by comparing the temperature T1 of the battery pack 20 with the sign upper limit temperature threshold TT2 (see FIG. 7). In this preferred embodiment, the determination controller 54 determines whether the temperature T1 (herein, the main temperature T1a and the sub temperature T1b) of the battery pack 20 acquired by the temperature acquisition controller 53 is equal to or more than the sign upper limit temperature threshold TT2. Then, when at least one of the main temperature T1a and the sub temperature T1b is equal to or more than the sign upper limit temperature threshold TT2, the determination controller 54 determines that the electricity storage unit 10 has the battery abnormality sign S2 and the process proceeds to Step S117 of FIG. 6.

On the other hand, in Step S115 of FIG. 6, when each of both the main temperature T1a and the sub temperature T1b is less than the sign upper limit temperature threshold TT2, the determination controller 54 determines that the electricity storage unit 10 does not have the battery abnormality sign S2, the process proceeds to Step S119. In the above-described manner, determination on an abnormality of the electricity storage unit 10 can be performed using the temperature T1 of the battery pack 20 in accordance with the flowchart of FIG. 6.

As has been described above, in this preferred embodiment, as illustrated in FIG. 1, the electricity storage system 100 includes the load 5 and the multiple electricity storage units 10 connected to the load 5. Each of the electricity storage units 10 is connected to the load 5 and includes the battery pack 20 including the multiple battery cells 22, the contactor 30 provided between the battery pack 20 and the load 5, and the controller 50. As illustrated in FIG. 2, the controller 50 includes the determination controller 54 and the supply limiting controller 56. The determination controller 54 determines whether an abnormality S0 (see FIG. 3) has occurred in the electricity storage unit 10. When it is determined by the determination controller 54 that the abnormality S0 has occurred in the electricity storage unit 10, the supply limiting controller 56 limits the maximum amount of electric power that is supplied to the load 5 in a stepwise manner in accordance with a level of the abnormality S0 of the electricity storage unit 10. Thus, when the abnormality S0 has occurred in any one of the multiple electricity storage units 10, the maximum amount of electric power that is supplied to the load 5 is limited in a stepwise manner in accordance with the level of the abnormality S0 of the electricity storage unit 10 in which the abnormality has occurred. Accordingly, even when the abnormality S0 has occurred in the electricity storage unit 10, in accordance with a type of the abnormality S0, electric power in an amount as large as possible can be supplied to the load 5.

In this preferred embodiment, as illustrated in FIG. 1, the electricity storage system 100 includes the voltage sensor 42 that detects the voltage value V1 of the battery pack 20. As illustrated in FIG. 3, the abnormality S0 of the battery pack 20 includes the battery abnormality S1 that is an abnormality of the battery pack 20 and the battery abnormality sign S2 that indicates a state where it is highly likely that the battery pack 20 will have the battery abnormality S1. As illustrated in FIG. 2, the controller 50 includes the voltage acquisition controller 52 and the supply controller 58. The voltage acquisition controller 52 acquires the voltage value V1 of the battery pack 20 in Step S101 of FIG. 6. When the electricity storage unit 10 is normal, the supply controller 58 sets the maximum amount of electric power that is supplied to the load 5 from the electricity storage unit 10 to the preset reference electric power amount NP1 in Step S119 of FIG. 6. When the voltage value V1 of the battery pack 20 acquired by the voltage acquisition controller 52 is equal to or more than the preset battery upper limit voltage threshold TV11 (see FIG. 4), the determination controller 54 determines that the electricity storage unit 10 has the battery abnormality S1. When the voltage value V1 of the battery pack 20 is equal to or lower than the preset battery lower limit voltage threshold TV12 (see FIG. 5), the determination controller 54 determines that the electricity storage unit 10 has the battery abnormality S1. When it is determined by the determination controller 54 that the electricity storage unit 10 has the battery abnormality S1, in Step S113 of FIG. 6, the supply limiting controller 56 performs control such that electric power is not supplied to the load 5 from the electricity storage unit 10. Thus, the battery abnormality S1 of the electricity storage unit 10 can be detected by comparing the voltage value V1 of the battery pack 20 with the battery upper limit voltage threshold TV11 and the battery lower limit voltage threshold TV12. For example, even when the first electricity storage unit 10a has the battery abnormality S1 and the maximum amount of electric power that can be supplied is 0, electric power in an amount that corresponds to the reference electric power amount NP1 (for example, electric power in an amount of about 40% of the maximum amount of electric power of the entire electricity storage system 100 in a normal state) can be supplied to the load 5 by the second electricity storage unit 10b.

In this preferred embodiment, when the voltage value V1 of the battery pack 20 is equal to or more than the preset sign upper limit voltage threshold TV21 (see FIG. 4) that is smaller than the battery upper limit voltage threshold TV11 and is less than the battery upper limit voltage threshold TV11, the determination controller 54 determines that the electricity storage unit 10 has the battery abnormality sign S2. When the voltage value V1 of the battery pack 20 is equal to or less than the preset sign lower limit voltage threshold TV22 (see FIG. 5) that is larger than the battery lower limit voltage threshold TV12, and is larger than the battery lower limit voltage threshold TV12, the determination controller 54 determines that the electricity storage unit 10 has the battery abnormality sign S2. When it is determined by the determination controller 54 that the electricity storage unit 10 has the battery abnormality sign S2, as in Step S117 of FIG. 6, the supply limiting controller 56 limits the maximum amount of electric power that is supplied to the load 5 to the maximum amount of electric power that corresponds to the preset sign abnormality ratio P2 with respect to the reference electric power amount NP1. Thus, the battery abnormality sign S2 of the electricity storage unit 10 can be detected by comparing the voltage value V1 of the battery pack 20 with the sign upper limit voltage threshold TV21 and the sign lower limit voltage threshold TV22. For example, even when the first electricity storage unit 10a has the battery abnormality sign S2 and the maximum amount of electric power that can be supplied is the reference electric power amount NP1 × the sign abnormality ratio P2, electric power in an amount that corresponds to the reference electric power amount NP1 can be further supplied to the load 5 by the second electricity storage unit 10b.

In this preferred embodiment, as illustrated in FIG. 3, the abnormality S0 of the electricity storage unit 10 includes the acquisition abnormality S4 that is an abnormality related to the voltage value V1 of the battery pack 20 acquired by the voltage acquisition controller 52. When the voltage value V1 of the battery pack 20 acquired by the voltage acquisition controller 52 is equal to or more than the preset acquisition upper limit voltage threshold TV41 (see FIG. 4) that is larger than the battery upper limit voltage threshold TV11, the determination controller 54 determines that the electricity storage unit 10 has the acquisition abnormality S4. When the voltage value V1 of the battery pack 20 is equal to or less than the preset acquisition lower limit voltage threshold TV42 (see FIG. 5) that is smaller than the battery lower limit voltage threshold TV12, the determination controller 54 determines that the electricity storage unit 10 has the acquisition abnormality S4. When it is determined by the determination controller 54 that the electricity storage unit 10 has the acquisition abnormality S4, in Step S105 of FIG. 6, the supply limiting controller 56 limits the maximum amount of electric power that is supplied to the load 5 to the maximum amount of electric power that corresponds to the preset acquisition abnormality ratio P4 with respect to the reference electric power amount NP1. Herein, the acquisition abnormality ratio P4 is smaller than the sign abnormality ratio P2. Thus, the acquisition abnormality S4 of the electricity storage unit 10 can be detected by comparing the voltage value V1 of the battery pack 20 with the acquisition upper limit voltage threshold TV41 and the acquisition lower limit voltage threshold TV42. For example, even when the first electricity storage unit 10a has the acquisition abnormality S4 and the maximum amount of electric power that can be supplied is the reference electric power amount NP1 × the acquisition abnormality ratio P4, electric power in an amount that corresponds to the reference electric power amount NP1 can be further supplied to the load 5 by the second electricity storage unit 10b.

In this preferred embodiment, as illustrated in FIG. 1, the voltage sensor 42 includes the main voltage sensor 42a and the sub voltage sensor 42b. The voltage acquisition controller 52 acquires the main voltage value V1a detected by the main voltage sensor 42a and the sub voltage value V1b detected by the sub voltage sensor 42b. When the difference between the main voltage value V1a and the sub voltage value V1b is equal to or more than the preset monitoring voltage threshold TV3 (see FIG. 2), the determination controller 54 determines that the electricity storage unit 10 has the monitoring abnormality S3. When it is determined by the determination controller 54 that the electricity storage unit 10 has the monitoring abnormality S3, as in S109 of FIG. 6, the supply limiting controller 56 limits the maximum amount of electric power that is supplied to the load 5 to the maximum amount of electric power that corresponds to the preset monitoring abnormality ratio P3 with respect to the reference electric power amount NP1. The monitoring abnormality ratio P3 is smaller than the acquisition abnormality ratio P4. Thus, the monitoring abnormality S3 of the electricity storage unit 10 can be detected by comparing the difference between the main voltage value V1a and the sub voltage value V1b. For example, even when the first electricity storage unit 10a has the monitoring abnormality S3 and the maximum amount of electric power that can be supplied is the reference electric power amount NP1 × the monitoring abnormality ratio P3, electric power in an amount that corresponds to the reference electric power amount NP1 can be further supplied by the second electricity storage unit 10b.

In this preferred embodiment, as illustrated in FIG. 4, the voltage value of the battery pack 20 when the SOC of the battery pack 20 is 100% is the reference upper limit voltage value NV11. The battery upper limit voltage threshold TV11 is higher than the reference upper limit voltage value NV11. Herein, each of the sign upper limit voltage threshold TV21 and the acquisition upper limit voltage threshold TV41 is higher than the reference upper limit voltage value NV11. Then, when the voltage value V1 of the battery pack 20 is higher than the reference upper limit voltage value NV11, it is highly likely that some kind of abnormality has occurred in the electricity storage unit 10. Thus, the battery abnormality S1, the battery abnormality sign S2, and the acquisition abnormality S4 can be detected by setting the thresholds TV11, TV21, and TV41, based on the reference upper limit voltage value NV11.

As illustrated in FIG. 5, in this preferred embodiment, the voltage value of the battery pack 20 when the SOC of the battery pack 20 is 0% is the reference lower limit voltage value NV12. The battery lower limit voltage threshold TV12 is lower than the reference lower limit voltage value NV12. Herein, each of the sign lower limit voltage threshold TV22 and the acquisition lower limit voltage threshold TV42 is lower than the reference lower limit voltage value NV12. Then, when the voltage value V1 of the battery pack 20 is lower than the reference lower limit voltage value NV12, it is highly likely that some kind of abnormality has occurred in the electricity storage unit 10. Thus, the battery abnormality S1, the battery abnormality sign S2, and the acquisition abnormality S4 can be detected by setting the thresholds TV12, TV22, and TV42, based on the reference lower limit voltage value NV12.

In this preferred embodiment, as illustrated in FIG. 1, the electricity storage unit 10 includes the temperature sensor 44 that detects the temperature T1 of the battery pack 20. The temperature acquisition controller 53 (see FIG. 2) of the controller 50 acquires the temperature of the battery pack 20. When the temperature T1 of the battery pack 20 acquired by the temperature acquisition controller 53 is equal to or more than the preset battery upper limit temperature threshold TT1 (see FIG. 7), the determination controller 54 determines that the electricity storage unit 10 has the battery abnormality S1. When the temperature T1 of the battery pack 20 is equal to or more than the preset sign upper limit temperature threshold TT2 (see FIG. 7) that is smaller than the battery upper limit temperature threshold TT1, and is less than the battery upper limit temperature threshold TT1, the determination controller 54 determines that the electricity storage unit 10 has the battery abnormality sign S2. As described above, the battery abnormality S1 of the electricity storage unit 10 can be detected by comparing the temperature T1 of the battery pack 20 with the battery upper limit temperature threshold TT1. The battery abnormality sign S2 of the electricity storage unit 10 can be detected by the comparing the temperature T1 of the battery pack 20 with the sign upper limit temperature threshold TT2.

In this preferred embodiment, when the temperature T1 of the battery pack 20 acquired by the temperature acquisition controller 53 is equal to or more than the preset acquisition upper limit temperature threshold TT4 (see FIG. 7) that is larger than the battery upper limit temperature threshold TT1, the determination controller 54 determines that the electricity storage unit 10 has the acquisition abnormality S4. Thus, the acquisition abnormality S4 of the electricity storage unit 10 can be detected by comparing the temperature T1 of the battery pack 20 with the acquisition upper limit temperature threshold TT4.

In this preferred embodiment, as illustrated in FIG. 1, the temperature sensor 44 includes the main temperature sensor 44a and the sub temperature sensor 44b. The temperature acquisition controller 53 acquires the main temperature T1a detected by the main temperature sensor 44a and the sub temperature T1b detected by the sub temperature sensor 44b. When the difference between the main temperature T1a and the sub temperature T1b is equal to or more than the preset monitoring temperature threshold TT3 (see FIG. 2), the determination controller 54 determines that the electricity storage unit 10 has the monitoring abnormality S3. As described above, the monitoring abnormality S3 of the electricity storage unit 10 can be detected by comparing the difference between the main temperature T1a and the sub temperature T1b.

In this preferred embodiment, a limiting method in which, in the electricity storage system 100 including the load 5 and the multiple electricity storage units 10 connected to the load 5, the maximum amount of electric power that is supplied to the load 5 from the electricity storage unit 10 is limited is provided. The limiting method includes a voltage acquisition step, a temperature acquisition step, a determination step, a supply limiting step, and a supplying step. Herein, the limiting method is embodied by the controller 50. The voltage acquisition step, the temperature acquisition step, the determination step, the supply limiting step, and the supplying step included in the limiting method are embodied by the voltage acquisition controller 52, the temperature acquisition controller 53, the determination controller 54, the supply limiting controller 56, and the supply controller 58, respectively.

The invention disclosed herein has been described above in various forms. However, the preferred embodiments described above or the like shall not limit the present invention, unless specifically stated otherwise. Various changes can be made to the preferred embodiments of the invention disclosed herein, and each of components and processes described herein can be omitted as appropriate or can be combined with another one or other ones of the components and the processes as appropriate, unless a particular problem occurs.

As described above, the present specification includes disclosure set forth in the following items.
First item: An electricity storage system including a load, and multiple electricity storage units connected to the load, in which each of the electricity storage units includes a battery pack connected to the load and including multiple battery cells, a contactor provided between the battery pack and the load, and a controller, and the controller includes a determination controller that determines whether an abnormality has occurred in the electricity storage unit, and a supply limiting controller that, when it is determined by the determination controller that an abnormality has occurred in the electricity storage unit, limits a maximum amount of electric power that is supplied to the load in a stepwise manner in accordance with a level of the abnormality of the electricity storage unit.

Second Item: The electricity storage system according to the first item, in which the electricity storage unit includes a voltage sensor that detects a voltage value of the battery pack, the abnormality of the electricity storage unit includes a battery abnormality that is an abnormality of the battery pack, and a battery abnormality sign that indicates a state where it is highly likely that the battery pack will have the battery abnormality, the controller includes a voltage acquisition controller that acquires the voltage value of the battery pack, and a supply controller that, when the electricity storage unit is normal, sets the maximum amount of electric power that is supplied to the load from the electricity storage unit to a preset reference electric power amount, when the voltage value of the battery pack acquired by the voltage acquisition controller is equal to or more than a preset battery upper limit voltage threshold, the determination controller determines that the electricity storage unit has the battery abnormality, when the voltage value of the battery pack acquired by the voltage acquisition controller is equal to or more than a preset sign upper limit voltage threshold that is smaller than the battery upper limit voltage threshold and is less than the battery upper limit voltage threshold, the determination controller determines that the electricity storage unit has the battery abnormality sign, when it is determined by the determination controller that the electricity storage unit has the battery abnormality, the supply limiting controller performs control such that electric power is not supplied to the load from the electricity storage unit, and when it is determined by the determination controller that the electricity storage unit has the battery abnormality sign, the supply limiting controller limits the maximum amount of electricity power that is supplied to the load to a maximum amount of electric power that corresponds to a preset sign abnormality ratio with respect to the reference electric power amount.

Third Item: The electricity storage system according to the second item, in which the abnormality of the electricity storage unit includes an acquisition abnormality that is an abnormality related to the voltage value of the battery pack acquired by the voltage acquisition controller, when the voltage value of the battery pack acquired by the voltage acquisition controller is equal to or more than a preset acquisition upper limit voltage threshold that is larger than the battery upper limit voltage threshold, the determination controller determines that the electricity storage unit has the acquisition abnormality, when it is determined by the determination controller that the electricity storage unit has the acquisition abnormality, the supply limiting controller limits the maximum amount of electric power that is supplied to the load to a maximum amount of electric power that corresponds to a preset acquisition abnormality ratio with respect to the reference electric power amount, and the acquisition abnormality ratio is smaller than the sign abnormality ratio.

Fourth Item: The electricity storage system according to the third item, in which the voltage sensor includes a main voltage sensor and a sub voltage sensor, the voltage acquisition controller acquires a main voltage value detected by the main voltage sensor and a sub voltage value detected by the sub voltage sensor, the abnormality of the electricity storage unit includes a monitoring abnormality, when a difference between the main voltage value and the sub voltage value is equal to or more than a preset monitoring voltage threshold, the determination controller determines that the electricity storage unit has the monitoring abnormality, when it is determined by the determination controller that the electricity storage unit has the monitoring abnormality, the supply limiting controller limits the maximum amount of electric power that is supplied to the load to a maximum amount of electric power that corresponds to a preset monitoring abnormality ratio with respect to the reference electric power amount, and the monitoring abnormality ratio is smaller than the acquisition abnormality ratio.

Fifth Item: The electricity storage system according to any one of the second to fourth items, in which when the voltage value of the battery pack when SOC of the battery pack is 100% is a reference upper limit voltage value, the battery upper limit voltage threshold is higher than the reference upper limit voltage value.

Sixth Item: The electricity storage system according to any one of the second to fifth items, in which when the voltage value of the battery pack acquired by the voltage acquisition controller is equal to or less than a preset battery lower limit voltage threshold, the determination controller determines that the electricity storage unit has the battery abnormality, and when the voltage value of the battery pack acquired by the voltage acquisition controller is equal to or less than a preset sign lower limit voltage threshold that is larger than the battery lower limit voltage threshold and is larger than the battery lower limit voltage threshold, the determination controller determines that the electricity storage unit has the battery abnormality sign.

Seventh Item: The electricity storage system according to the sixth item, in which the abnormality of the electricity storage unit includes an acquisition abnormality that is an abnormality related to the voltage value of the battery pack acquired by the voltage acquisition controller, when the voltage value of the battery pack acquired by the voltage acquisition controller is equal to or less than a preset acquisition lower limit voltage threshold that is smaller than the battery lower limit voltage threshold, the determination controller determines that the electricity storage unit has the acquisition abnormality, when it is determined by the determination controller that the electricity storage unit has the acquisition abnormality, the supply limiting controller limits the maximum amount of electric power that is supplied to the load to a maximum amount of electric power that corresponds to a preset acquisition abnormality ratio with respect to the reference electric power amount, and the acquisition abnormality ratio is smaller than the sign abnormality ratio.

Eighth Item: The electricity storage system according to the sixth or seventh item, in which when the voltage value of the battery pack when the SOC of the battery pack is 0% is a reference lower limit voltage value, the battery lower limit voltage threshold is lower than the reference lower limit voltage value.

Ninth Item: The electricity storage system according to the first item, in which the electricity storage unit includes a temperature sensor that detects a temperature of the battery pack, the abnormality of the electricity storage unit includes a battery abnormality that is an abnormality of the battery pack, and a battery abnormality sign that indicates a state where it is highly likely that the battery pack will have the battery abnormality, the controller includes a temperature acquisition controller that acquires the temperature of the battery pack, and a supply controller that, when the electricity storage unit is normal, sets the maximum amount of electric power that is supplied to the load from the electricity storage unit to a preset reference electric power amount, when the temperature of the battery pack acquired by the temperature acquisition controller is equal to or more than a preset battery upper limit temperature threshold, the determination controller determines that the electricity storage unit has the battery abnormality, when the temperature of the battery pack acquired by the temperature acquisition controller is equal to or more than a preset sign upper limit temperature threshold that is smaller than the battery upper limit temperature threshold and is less than the battery upper limit temperature threshold, the determination controller determines that the electricity storage unit has the battery abnormality sign, when it is determined by the determination controller that the electricity storage unit has the battery abnormality, the supply limiting controller performs control such that electric power is not supplied to the load from the electricity storage unit, and when it is determined by the determination controller that the electricity storage unit has the battery abnormality sign, the supply limiting controller limits the maximum amount of electric power that is supplied to the load to a maximum amount of electric power that corresponds to a preset sign abnormality ratio with respect to the reference electric power amount.

Tenth Item: The electricity storage system according to the ninth item, in which the abnormality of the electricity storage unit includes an acquisition abnormality that is an abnormality related to the temperature of the battery pack acquired by the temperature acquisition controller, when the temperature of the battery pack acquired by the temperature acquisition controller is equal to or more than a preset acquisition upper limit temperature threshold that is larger than the battery upper limit temperature threshold, the determination controller determines that the electricity storage unit has the acquisition abnormality, when it is determined by the determination controller that the electricity storage unit has the acquisition abnormality, the supply limiting controller limits the maximum amount of electric power that is supplied to the load to a maximum amount of electric power that corresponds to a preset acquisition abnormality ratio with respect to the reference electric power amount, and the acquisition abnormality ratio is smaller than the sign abnormality ratio.

Eleventh Item: The electricity storage system according to the tenth item, in which the temperature sensor includes a main temperature sensor and a sub temperature sensor, the temperature acquisition controller acquires a main temperature detected by the main temperature sensor and a sub temperature detected by the sub temperature sensor, the abnormality of the electricity storage unit includes a monitoring abnormality, when a difference between the main temperature and the sub temperature is equal to or more than a preset monitoring temperature threshold, the determination controller determines that the electricity storage unit has the monitoring abnormality, when it is determined by the determination controller that the electricity storage unit has the monitoring abnormality, the supply limiting controller limits the maximum amount of electric power that is supplied to the load to a maximum amount of electric power that corresponds to a preset monitoring abnormality ratio with respect to the reference electric power amount, and the monitoring abnormality ratio is smaller than the acquisition abnormality ratio.

Twelfth Item: A limiting method in which, in an electricity storage system including a load and multiple electricity storage units connected to the load, a maximum amount of electric power that is supplied to the load from the electricity storage units is limited, each of the electricity storage units including a battery pack that is connected to the load and includes multiple battery cells, and a contactor provided between the battery pack and the load, the limiting method including a determination step of determining whether an abnormality has occurred in the electricity storage unit, and a supply limiting step of limiting, when it is determined in the determination step that an abnormality has occurred in the electricity storage unit, the maximum amount of electric power that is supplied to the load in a stepwise manner in accordance with a level of the abnormality of the electricity storage unit.

## Claims

1. An electricity storage system (100) comprising:
a load (5); and
multiple electricity storage units (10) connected to the load (5),
wherein
each of the electricity storage units (10) includes
a battery pack (20) connected to the load (5) and including multiple battery cells (22),
a contactor (30) provided between the battery pack (20) and the load (5), and
a controller (50), and
the controller (50) includes
a determination controller (54) that determines whether an abnormality (S0) has occurred in the electricity storage unit (10), and
a supply limiting controller (56) that, when it is determined by the determination controller (54) that an abnormality (S0) has occurred in the electricity storage unit (10), limits a maximum amount of electric power that is supplied to the load (5) in a stepwise manner in accordance with a level of the abnormality (S0) of the electricity storage unit (10).

2. The electricity storage system (100) according to claim 1, wherein
the electricity storage unit (10) includes a voltage sensor (42) that detects a voltage value (V1) of the battery pack (20),
the abnormality (S0) of the electricity storage unit (10) includes
a battery abnormality (S1) that is an abnormality of the battery pack (20), and
a battery abnormality sign (S2) that indicates a state where it is highly likely that the battery pack (20) will have the battery abnormality (S1),
the controller (50) includes
a voltage acquisition controller (52) that acquires the voltage value (V1) of the battery pack (20), and
a supply controller (58) that, when the electricity storage unit (10) is normal, sets the maximum amount of electric power that is supplied to the load (5) from the electricity storage unit (10) to a preset reference electric power amount (NP1),
when the voltage value (V1) of the battery pack (20) acquired by the voltage acquisition controller (52) is equal to or more than a preset battery upper limit voltage threshold (TV11), the determination controller (54) determines that the electricity storage unit (10) has the battery abnormality (S1),
when the voltage value (V1) of the battery pack (20) acquired by the voltage acquisition controller (52) is equal to or more than a preset sign upper limit voltage threshold (TV21) that is smaller than the battery upper limit voltage threshold (TV11) and is less than the battery upper limit voltage threshold (TV11), the determination controller (54) determines that the electricity storage unit (10) has the battery abnormality sign (S2),
when it is determined by the determination controller (54) that the electricity storage unit (10) has the battery abnormality (S1), the supply limiting controller (56) performs control such that electric power is not supplied to the load (5) from the electricity storage unit (10), and
when it is determined by the determination controller (54) that the electricity storage unit (10) has the battery abnormality sign (S2), the supply limiting controller (56) limits the maximum amount of electricity power that is supplied to the load (5) to a maximum amount of electric power that corresponds to a preset sign abnormality ratio (P2) with respect to the reference electric power amount (NP1).

3. The electricity storage system (100) according to claim 2, wherein
the abnormality (S0) of the electricity storage unit (10) includes an acquisition abnormality (S4) that is an abnormality related to the voltage value (V1) of the battery pack (20) acquired by the voltage acquisition controller (52),
when the voltage value (V1) of the battery pack (20) acquired by the voltage acquisition controller (52) is equal to or more than a preset acquisition upper limit voltage threshold (TV41) that is larger than the battery upper limit voltage threshold (TV11), the determination controller (54) determines that the electricity storage unit (10) has the acquisition abnormality (S4),
when it is determined by the determination controller (54) that the electricity storage unit (10) has the acquisition abnormality (S4), the supply limiting controller (56) limits the maximum amount of electric power that is supplied to the load (5) to a maximum amount of electric power that corresponds to a preset acquisition abnormality ratio (P4) with respect to the reference electric power amount (NP1), and
the acquisition abnormality ratio (P4) is smaller than the sign abnormality ratio (P2).

4. The electricity storage system (100) according to claim 3, wherein
the voltage sensor (42) includes a main voltage sensor (42a) and a sub voltage sensor (42b),
the voltage acquisition controller (52) acquires a main voltage value (V1a) detected by the main voltage sensor (42a) and a sub voltage value (V1b) detected by the sub voltage sensor (42b),
the abnormality (S0) of the electricity storage unit (10) includes a monitoring abnormality (S3),
when a difference between the main voltage value (V1a) and the sub voltage value (V1b) is equal to or more than a preset monitoring voltage threshold (TV3), the determination controller (54) determines that the electricity storage unit (10) has the monitoring abnormality (S3),
when it is determined by the determination controller (54) that the electricity storage unit (10) has the monitoring abnormality (S3), the supply limiting controller (56) limits the maximum amount of electric power that is supplied to the load (5) to a maximum amount of electric power that corresponds to a preset monitoring abnormality ratio (P3) with respect to the reference electric power amount (NP1), and
the monitoring abnormality ratio (P3) is smaller than the acquisition abnormality ratio (P4).

5. The electricity storage system (100) according to any one of claims 2 to 4, wherein
when the voltage value (V1) of the battery pack (20) when SOC of the battery pack (20) is 100% is a reference upper limit voltage value (NV11),
the battery upper limit voltage threshold (TV11) is higher than the reference upper limit voltage value (NV11).

6. The electricity storage system (100) according to any one of claims 2 to 5 wherein
when the voltage value (V1) of the battery pack (20) acquired by the voltage acquisition controller (52) is equal to or less than a preset battery lower limit voltage threshold (TV12), the determination controller (54) determines that the electricity storage unit (10) has the battery abnormality (S1), and
when the voltage value (V1) of the battery pack (20) acquired by the voltage acquisition controller (52) is equal to or less than a preset sign lower limit voltage threshold (TV22) that is larger than the battery lower limit voltage threshold (TV12) and is larger than the battery lower limit voltage threshold (TV12), the determination controller (54) determines that the electricity storage unit (10) has the battery abnormality sign (S2).

7. The electricity storage system (100) according to claim 6, wherein
the abnormality (S0) of the electricity storage unit (10) includes an acquisition abnormality (S4) that is an abnormality related to the voltage value (V1) of the battery pack (20) acquired by the voltage acquisition controller (52),
when the voltage value (V1) of the battery pack (20) acquired by the voltage acquisition controller (52) is equal to or less than a preset acquisition lower limit voltage threshold (TV42) that is smaller than the battery lower limit voltage threshold (TV12), the determination controller (54) determines that the electricity storage unit (10) has the acquisition abnormality (S4),
when it is determined by the determination controller (54) that the electricity storage unit (10) has the acquisition abnormality (S4), the supply limiting controller (56) limits the maximum amount of electric power that is supplied to the load (5) to a maximum amount of electric power that corresponds to a preset acquisition abnormality ratio (P4) with respect to the reference electric power amount (NP1), and
the acquisition abnormality ratio (P4) is smaller than the sign abnormality ratio (P2).

8. The electricity storage system (100) according to claim 6 or 7, wherein
when the voltage value (V1) of the battery pack (20) when the SOC of the battery pack (20) is 0% is a reference lower limit voltage value (NV12),
the battery lower limit voltage threshold (TV12) is lower than the reference lower limit voltage value (NV12).

9. The electricity storage system (100) according to claim 1, wherein
the electricity storage unit (10) includes a temperature sensor (44) that detects a temperature (T1) of the battery pack (20),
the abnormality (S0) of the electricity storage unit (10) includes
a battery abnormality (S1) that is an abnormality of the battery pack (20), and
a battery abnormality sign (S2) that indicates a state where it is highly likely that the battery pack (20) will have the battery abnormality (S1),
the controller (50) includes
a temperature acquisition controller (53) that acquires the temperature (T1) of the battery pack (20), and
a supply controller (58) that, when the electricity storage unit (10) is normal, sets the maximum amount of electric power that is supplied to the load (5) from the electricity storage unit (10) to a preset reference electric power amount (NP1),
when the temperature (T1) of the battery pack (20) acquired by the temperature acquisition controller (53) is equal to or more than a preset battery upper limit temperature threshold (TT1), the determination controller (54) determines that the electricity storage unit (10) has the battery abnormality (S1),
when the temperature (T1) of the battery pack (20) acquired by the temperature acquisition controller (53) is equal to or more than a preset sign upper limit temperature threshold (TT2) that is smaller than the battery upper limit temperature threshold (TT1) and is less than the battery upper limit temperature threshold (TT1), the determination controller (54) determines that the electricity storage unit (10) has the battery abnormality sign (S2),
when it is determined by the determination controller (54) that the electricity storage unit (10) has the battery abnormality (S 1), the supply limiting controller (56) performs control such that electric power is not supplied to the load (5) from the electricity storage unit (10), and
when it is determined by the determination controller (54) that the electricity storage unit (10) has the battery abnormality sign (S2), the supply limiting controller (56) limits the maximum amount of electric power that is supplied to the load (5) to a maximum amount of electric power that corresponds to a preset sign abnormality ratio (P2) with respect to the reference electric power amount (NP1).

10. The electricity storage system (100) according to claim 9, wherein
the abnormality (S0) of the electricity storage unit (10) includes an acquisition abnormality (S4) that is an abnormality related to the temperature (T1) of the battery pack (20) acquired by the temperature acquisition controller (53),
when the temperature (T1) of the battery pack (20) acquired by the temperature acquisition controller (53) is equal to or more than a preset acquisition upper limit temperature threshold (TT4) that is larger than the battery upper limit temperature threshold (TT1), the determination controller (54) determines that the electricity storage unit (10) has the acquisition abnormality (S4),
when it is determined by the determination controller (54) that the electricity storage unit (10) has the acquisition abnormality (S4), the supply limiting controller (56) limits the maximum amount of electric power that is supplied to the load (5) to a maximum amount of electric power that corresponds to a preset acquisition abnormality ratio (P4) with respect to the reference electric power amount (NP1), and
the acquisition abnormality ratio (P4) is smaller than the sign abnormality ratio (P2).

11. The electricity storage system (100) according to claim 10, wherein
the temperature sensor (44) includes a main temperature sensor (44a) and a sub temperature sensor (44b),
the temperature acquisition controller (53) acquires a main temperature (T1a) detected by the main temperature sensor (44a) and a sub temperature (T1b) detected by the sub temperature sensor (44b),
the abnormality (S0) of the electricity storage unit (10) includes a monitoring abnormality (S3),
when a difference between the main temperature (T1a) and the sub temperature (T1b) is equal to or more than a preset monitoring temperature threshold (TT3), the determination controller (54) determines that the electricity storage unit (10) has the monitoring abnormality (S3),
when it is determined by the determination controller (54) that the electricity storage unit (10) has the monitoring abnormality (S3), the supply limiting controller (56) limits the maximum amount of electric power that is supplied to the load (5) to a maximum amount of electric power that corresponds to a preset monitoring abnormality ratio (P3) with respect to the reference electric power amount (NP1), and
the monitoring abnormality ratio (P3) is smaller than the acquisition abnormality ratio (P4).

12. A limiting method in which, in an electricity storage system (100) including a load (5) and multiple electricity storage units (10) connected to the load (5), a maximum amount of electric power that is supplied to the load (5) from the electricity storage units (10) is limited,
each of the electricity storage units (10) including
a battery pack (20) that is connected to the load (5) and includes multiple battery cells (22), and
a contactor (30) provided between the battery pack (20) and the load (5), the limiting method comprising:
a determination step of determining whether an abnormality (S0) has occurred in the electricity storage unit (10); and
a supply limiting step of limiting, when it is determined in the determination step that an abnormality (S0) has occurred in the electricity storage unit (10), the maximum amount of electric power that is supplied to the load (5) in a stepwise manner in accordance with a level of the abnormality (S0) of the electricity storage unit (10).
